(19) Europäisches Patentamt
European Patent Office
Office européen des brevets

(11) Veröffentlichungsnummer: **0 597 486 A2**

(12) **EUROPÄISCHE PATENTANMELDUNG**

(21) Anmeldenummer: **93118349.5**

(22) Anmeldetag: **12.11.93**

(51) Int. Cl.⁵: **H03L 7/099**

(30) Priorität: **13.11.92 DE 4238374**

(43) Veröffentlichungstag der Anmeldung:
**18.05.94 Patentblatt 94/20**

(84) Benannte Vertragsstaaten:
**ES FR GB IT**

(71) Anmelder: **Henze, Werner**
**Wietzendiek 13**
**D-30657 Hannover(DE)**

(72) Erfinder: **Henze, Werner**
**Wietzendiek 13**
**D-30657 Hannover(DE)**

(74) Vertreter: **Lins, Edgar, Dipl.-Phys. Dr.jur.**
**Patentanwälte Gramm + Lins**
**Theodor-Heuss-Strasse 1**
**D-38122 Braunschweig (DE)**

(54) **Schaltungsanordnung zur Erzeugung eines Signals mit einer steuerbaren stabilen Frequenz.**

(57) Bei einer Schaltungsanordnung zur Erzeugung eines Signals mit einer steuerbaren stabilen Frequenz wird mit Hilfe eines Quarzoszillators ein impulsförmiges Signal erzeugt. Bei Abweichungen der Frequenz des impulsförmigen Signals von der Sollfrequenz werden je nach Richtung der Abweichung einzelne Impulse hinzugefügt oder unterdrückt, so daß die Frequenz des resultierenden Signals gemittelt dem Sollwert entspricht.

Fig. 1

EP 0 597 486 A2

Die Erfindung geht aus von einer Schaltungsanordnung nach der Gattung des Hauptanspruchs.

Die Erfindung kann vorzugsweise bei dem in der Patentanmeldung P 42 05 015.4 der Anmelderin beschriebenen RDS-Demodulator angewandt werden.

Mit dem bekannten Radio-Daten-System können zusätzlich zu den Audiosignalen Datensignale übertragen werden, die beispielsweise den Namen des ausgestrahlten Programms oder andere Informationen enthalten. Um beim UKW-Stereo-Hörrundfunk die Kompatibilität mit den Audiosignalen sowie mit Verkehrsfunksignalen sicherzustellen, wird bei dem Radio-Daten-System der auch beim Verkehrsfunk verwendete Hilfsträger von 57 kHz mit den zu übertragenden Daten moduliert, wobei allerdings die Seitenbänder außerhalb der für verschiedene Signale des Verkehrsfunks benutzten Modulationsfrequenzen liegen. Es wird dabei eine Biphase-Codierung gewählt, die bewirkt, daß sich keine Spektralanteile bei 57 kHz ergeben und der Takt implizit mitübertragen wird. Das gesamte Spektrum des modulierten Radio-Daten-Signals, im folgenden auch RDS-Signal genannt, wird auf ±2,4 kHz begrenzt.

Bei RDS-Demodulatoren werden verschiedene Signale aus einem Signal mit einer Frequenz von 4,332 MHz abgeleitet, das mit Hilfe eines Quarzoszillators erzeugt wird. Diese Frequenz entspricht dem 76-fachen der Hilfsträgerfrequenz. Zur Regenerierung der Hilfsträgerfrequenz ist es wichtig, daß dieses ganzzahlige Verhältnis genau eingehalten wird. Die Schwingfrequenz eines in einem Rundfunkempfänger befindlichen Quarzoszillators hängt von mehreren Faktoren ab. Dazu gehören Herstellungstoleranzen des Quarzes, Toleranzen der beim Quarzoszillator verwendeten Bauelemente, thermische Einflüsse sowie im weiteren Verlauf die Alterung des Quarzes. Es ergeben sich Frequenzabweichungen gegenüber dem senderseitig erzeugten "Muttersignal".

Die Veränderung der Schwingfrequenz von Quarzoszillatoren durch Verändern von Kapazitäten ist zwar bekannt, der einstellbare Frequenzbereich ist dabei jedoch relativ klein. Außerdem ist ein Digital/Analog-Wandler erforderlich, der eine digital vorliegende Stellgröße in ein zur Änderung der Kapazität geeignetes Analogsignal umwandelt. Schließlich ergeben sich Verzögerungen durch das bei einer Frequenz- und Phasenregelschleife erforderliche Schleifenfilter.

Aufgabe der Erfindung ist es, eine Schaltungsanordnung zur Erzeugung eines Signals anzugeben, dessen Frequenz stabil ist und zum Beispiel mit einem Sollwert genau auf das 2x76-fache der Hilfsträgerfrequenz voreingestellt werden kann, womit das Einschwingen des Trägerregenerators praktisch entfällt und bei welcher Abweichungen innerhalb eines relativ großen Frequenzbereichs korrigierbar sind.

Diese Aufgabe wird mit den im kennzeichnenden Teil des Hauptanspruchs angegebenen Maßnahmen erfüllt. Bei der erfindungsgemäßen Schaltungsanordnung wird die erzeugte Frequenz beispielsweise an die Frequenz des senderseitig erzeugten Muttertaktsignals angepaßt. Mit der erfindungsgemäßen Schaltungsanordnung ist es möglich, eine Frequenzänderung des Ausgangssignals mit einer digitalen Sollwerteingabe zu erreichen, ohne daß der Quarzoszillator selbst beeinflußt wird.

Durch die in den Unteransprüchen aufgeführten Maßnahmen sind vorteilhafte Weiterbildungen und Verbesserungen der im Hauptanspruch angegebenen Erfindung möglich.

Ausführungsbeispiele der Erfindung sind in der Zeichnung anhand mehrerer Figuren dargestellt und in der nachfolgenden Beschreibung näher erläutert. Es zeigt:

Fig. 1    ein Blockschaltbild einer erfindungsgemäßen Schaltungsanordnung,

Fig. 2    eine Tabelle zur Verdeutlichung der Frequenzabweichungen und die dazu erforderliche Anzahl von Perioden,

Fig. 3    eine Tabelle, bei der der erforderlichen Anzahl von Perioden Sollwerte zugeordnet sind,

Fig. 4    den Inhalt einer bei der Schaltungsanordnung nach Fig. 1 verwendeten Matrix,

Fig. 5    eine schematische Darstellung der Frequenzeinstellungen mit Hilfe zweier Sollwerte,

Fig. 6    den Inhalt einer weiteren bei der Schaltungsanordnung nach Fig. 1 verwendeten Matrix,

Fig. 7    Zeitdiagramme von bei der Schaltungsanordnung nach Fig. 1 auftretenden Signalen,

Fig. 8    Zeitdiagramme von weiteren bei der Schaltungsanordnung nach Fig. 1 auftretenden Signalen im Falle einer Frequenzverringerung und

Fig. 9    dieselben Signale im Falle einer Frequenzerhöhung.

Gleiche Teile sind in den Figuren mit gleichen Bezugszeichen versehen. Zähler sind durch ein Symbol "0, 1, 2..." und Schieberegister mit "SR" gekennzeichnet. Dabei bedeutet "CL" Takteingang, "R" Rücksetzeingang, "D" Dateneingang und "LD" Load-Eingang. Bei Komparatoren sind die Eingangsgrößen mit A und B bezeichnet und die Ausgänge mit der jeweiligen Bedingung. Decoder, welche eine vom Inhalt eines Zählers abhängige Information erzeugen, sind durch den jeweiligen Zählerstand in eckigen Klammern gekennzeichnet. Einige Ein- und Ausgänge sind in mehreren Figuren mit Pfeilen und Ziffern versehen, die darauf hinweisen, von und zu welchen Teilen in anderen Figuren die entsprechenden Signale geleitet werden.

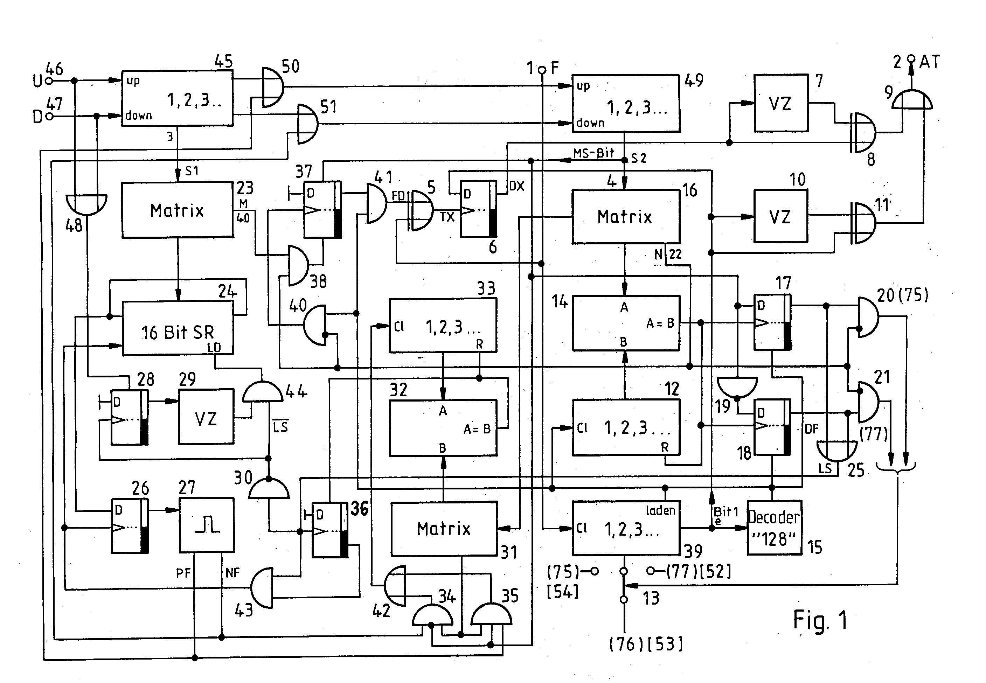

Die Schaltungsanordnung nach Fig. 1 weist einen Eingang 1 auf, dem ein von einem Quarzoszillator erzeugtes Signal F zuführbar ist, dessen Frequenz $f_q$ sich in einem Bereich zwischen 8,657 MHz und 8,671 MHz ändern kann, ohne daß das am Ausgang 2 entnehmbare Taktsignal AT von seiner Sollfrequenz 8,664 MHz abweicht. Dabei sind kurzzeitige frequenzkorrigierende Maßnahmen zugelassen. Sehr geringe Frequenzabweichungen vom Sollwert verbleiben durch die mit dem Sollwert einstellbaren Frequenzstufen am Ausgang 2. Im Durchschnitt behält das Signal AT jedoch relativ genau die Sollfrequenz bei. Über weitere Eingänge 3, 4 sind Sollwerte S1, S2 zuführbar, die jeweils von vier Bit breiten digitalen Signalen dargestellt werden. Die Frequenz AT am Ausgang 2 kann mit dem Sollwert S2 grob und mit dem Sollwert S1 fein eingestellt werden. Nachfolgend wird zunächst die grobe Frequenzeinstellung beschrieben.

Ein Zähler 39 wird mit dem Signal F getaktet und teilt somit die Frequenz $f_q$ des Signals F durch einen mit einem Umschalter 13 festlegbaren Teiler 75, 76 oder 77. Der Ausgang des Zählers 39 ist mit dem Eingang eines Decoders 15 verbunden. Der Decoder 15 erzeugt ein Signal DF, dessen Pegel den Wert "1" annimmt, wenn der Zähler den Zählerstand 128 erreicht hat. Die Zahl 128 kann hier ohne Schaltungsaufwand decodiert werden. Die Frequenz des Signals DF beträgt 114 kHz.

Diese Frequenz muß bei jeder Frequenz $f_q$ im Bereich von 8,657 MHz bis 8,671 MHz mit dem Zähler 39 erreicht werden können. Das Teilungsverhältnis ist deshalb veränderbar, wozu der Zähler 39 auf Werte geladen werden kann, die den Teilungsverhältnissen 77:1, 76:1 und 75:1 entsprechen. Da der Coder den Wert [128] decodiert und der Zähler 39 synchron mit dem Signal F geladen wird, muß ein Impulsintervall als Ladevorgang berücksichtigt werden, das heißt beim Teilungsverhältnis von 77:1 wird der Zähler auf 128 - (77 - 1) = 52 geladen. Entsprechend wird der Zähler 39 bei 76:1 auf 53 und bei 75:1 auf 54 geladen. Im Zusammenhang mit dem Umschalter 13 sind diese Werte zusammen mit den entsprechenden Teilungsverhältnissen in Fig. 1 dargestellt.

Mit einem der Teilungsverhältnisse wird die Sollfrequenz jedoch nur erreicht, wenn die Frequenz $f_q$ entweder ihren Sollwert oder einen der extremen Werte einnimmt. Um auch bei Zwischenwerten den Sollwert der Frequenz zu erreichen, wird zwischen den Teilungsverhältnissen umgeschaltet. Wenn die Frequenz $f_q$ zu niedrig ist, folgt nach n Perioden des Signals DF mit dem Teilungsverhältnis von 76:1 eine Periode mit dem Teilungsverhältnis 75:1. Ist die Frequenz $f_q$ zuhoch, wird von Zeit zu Zeit auf ein Teilungsverhältnis von 77:1 umgeschaltet.

Die Zahl n kann nach den folgenden Gleichungen berechnet werden:

$$n \cdot T = n \cdot 76 \cdot 1/f_q - 1/f_q \quad \text{für Teilungsverhältnisse}$$
$$n = 1/(76 - T \cdot f_q) \quad 76:1 \text{ und } 75:1$$
$$n \cdot T = n \cdot 76 \cdot 1/f_q + 1/f_q \quad \text{für Teilungsverhältnisse}$$
$$n = 1/(T \cdot f_q - 76) \quad 76:1 \text{ und } 77:1$$

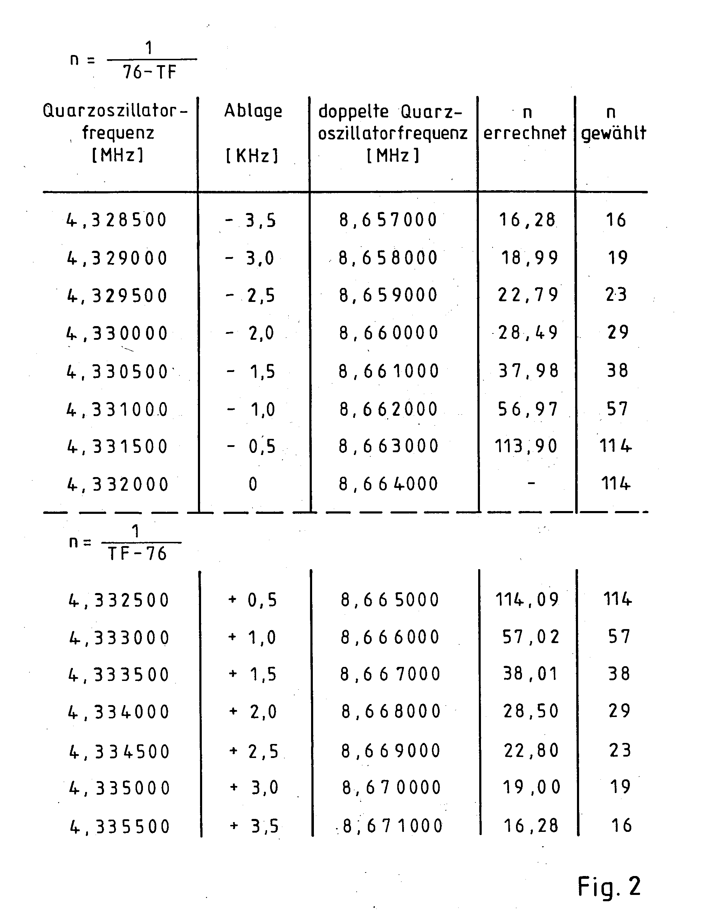

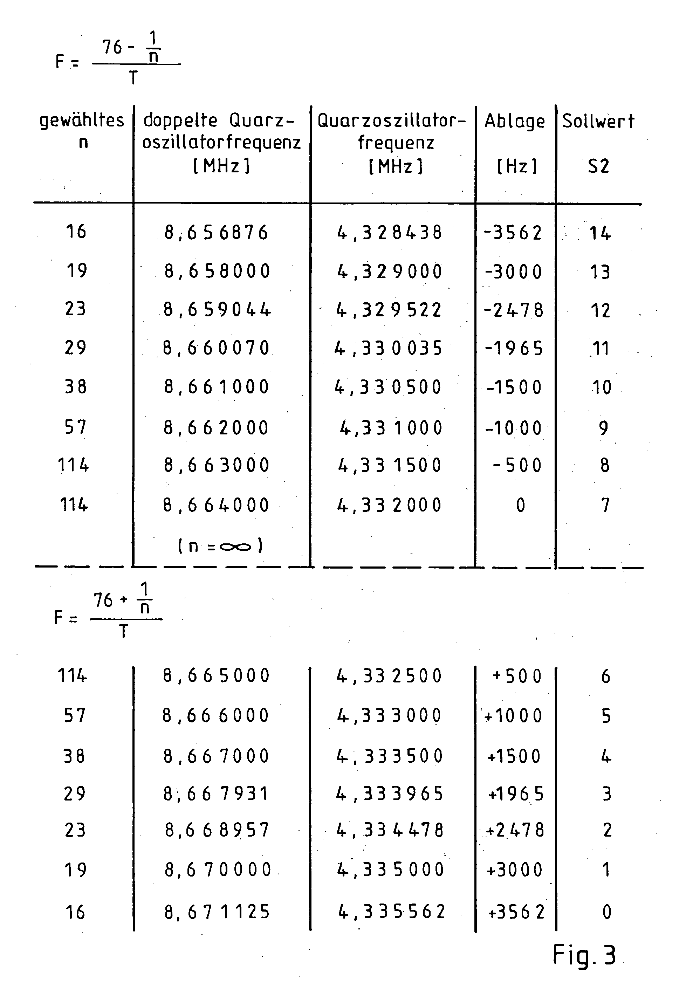

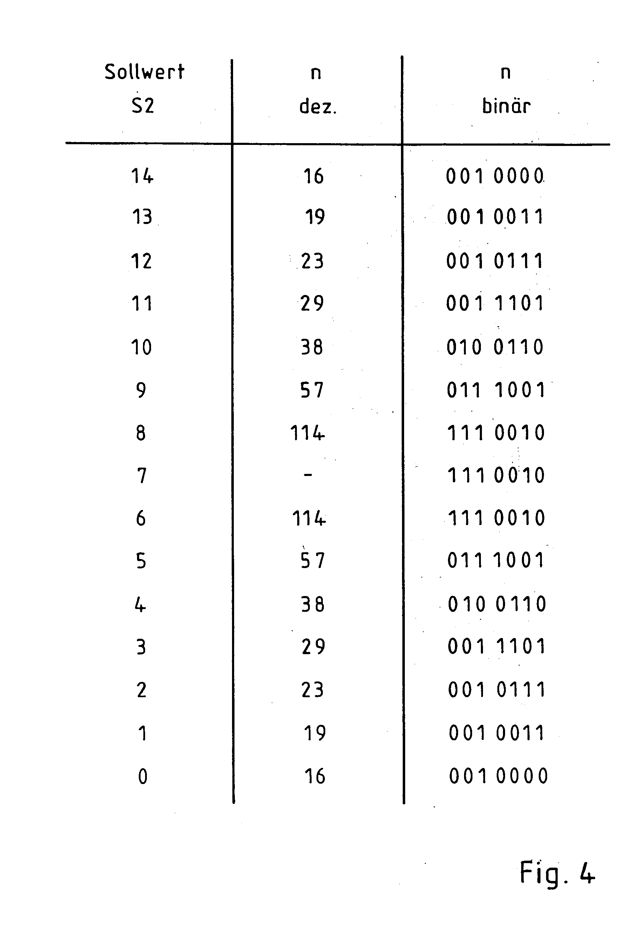

Fig. 2 zeigt eine Tabelle, in der errechnete Werte n angegeben sind, aus denen ganzzahlige Werte für n ableitbar sind. In Fig. 3 ist eine Tabelle dargestellt, bei der aus den ganzzahligen Werten n die Frequenzen $f_q$ und $f_q$ :2 errechnet sind. Den Werten n sind außerdem Sollwerte S2 zugeordnet, welche einen Bereich von 0 bis 14 einnehmen können. Diese Zuordnung ist in Fig. 4 dargestellt und als Matrix 16 Bestandteil der Schaltungsanordnung nach Fig. 1.

Um die gewünschte grobe Frequenzeinstellung zu erreichen, wird ein zugehöriger Wert S2 über den Eingang 4 der Matrix 16 als Binärzahl zugeführt. Dort wird die Zahl n, die dem jeweiligen Wert S2 entspricht, ausgelesen und einem Eingang A des Komparators 14 zugeführt. Der Zähler 12 zählt die Perioden des Zählers 39. Sein Takteingang ist deshalb mit dem Ausgang des Decoders 15 verbunden.

Mit Hilfe des Komparators 14 wird n mit dem Zählerstand des Zählers 12 verglichen. Stellt der Komparator 14 Gleichheit fest, werden in Abhängigkeit von dem Wert des höchstwertigen Bits (MSB) des Sollwertes S2 Flip-Flops 17, 18 gesetzt. Dazu ist die das MSB führende Leitung zwischen dem Eingang 4 und dem Eingang der Matrix 16 mit dem Dateneingang des Flip-Flops 17 und über einen Invertierer 19 mit dem Dateneingang des Flip-Flops 18 verbunden. Zum Setzzeitpunkt sind die Rücksetzeingänge der Flip-Flops 17 und 18 gleich 1. Die Ausgänge der Flip-Flops steuern über die Und-Schaltungen 20 oder 21 den Schalter 13. Mit dem nächsten Takt am Eingang des Zählers 39 wird der neue Wert in den Zähler 39 geladen. Nach dem Laden wird das Signal DF wieder 0. Das unter den Flip-Flops, 17 und 18 gesetzte wird damit wieder rückgesetzt.

Wenn jedoch der Sollwert S2 = 7 ist, die Frequenz $f_q$ also nicht verändert werden soll, nimmt ein an einem weiteren Ausgang 22 der Matrix 16 anstehendes Signal N den Pegel 1 ein. Dadurch werden die Und-Schaltungen 20, 22 für die Ausgangssignale der Flip-Flops 17, 18 gesperrt und der Schalter 13 wird in jedem Fall auf das Teilungsverhältnis 76:1 gestellt.

Aus dem zweitgeringstwertigsten Bit des Zählers 39 wird das Ausgangssignal AT abgeleitet. Dieses Signal ist in den Figuren 1, 8 und 9 mit e bezeichnet. Es wird auf zwei Wegen einer Oder-Schaltung 9 zugeführt. Im ersten Weg liegt eine Schaltung, die aus einer Verzögerung 10 und einer Exklusiv-Oder-Schaltung 11 gebildet wird. Im zweiten Weg gelangt das Signal e über das Flip-Flop 6 ebenfalls zu einer Schaltung, die aus einer Verzögerung 7 und einer Exklusiv-Oder-Schaltung 8 besteht. Mit dem Flip-Flop 6 wird das Signal e um eine Taktperiode des Signals F verzögert. Den Schaltungen 7, 8 und 10, 11 werden deshalb um 90° phasenverschobene Signale zugeführt. Mit den Schaltungen 7, 8 und 10, 11 wird jeweils aus jeder Signalflanke ein kurzer Impuls abgeleitet und der Oder-Schaltung 9 zugeführt.

Zur Frequenzkorrektur muß die Möglichkeit bestehen, Impulse im Signal AT hinzuzufügen und zu unterdrücken. Die Umschaltung zwischen Hinzufügen und Unterdrücken wird mit dem Flip-Flop 37 getroffen. Es wird gesetzt, sobald das MS-Bit des Sollwertes S2 den Wert 1 annimmt. Das Flip-Flop 37 wird über den Rücksetzeingang mit dem Ausgangssignal der Und-Schaltung 38 rückgesetzt, wenn das Ausgangssignal N der Matrix 16 gleich 1 ist, das heißt, wenn S2 = 7 ist und das Ausgangssignal M am Ausgang 40 der Matrix 23 gleich 1 ist, das heißt, wenn S1 = 0 ist.

Das Flip-Flop wird außerdem mit dem vom Decoder 15 kommenden Taktimpuls DF mit Hilfe der Und-Schaltung 40 rückgesetzt, wenn S2 # 7 ist, das heißt, wenn das Ausgangssignal N der Matrix 16 gleich 0 ist. Das Rücksetzen ist allerdings nur möglich, wenn der Sollwert S2 einen Wert im Bereich 0 bis 6 hat. Ansonsten bleibt das Flip-Flop 37 wegen des MS-Bits des Sollwertes S2 gesetzt. Mit dem Signal F am Eingang 1 wird mit einer Exklusiv-Oder-Schaltung 5 der Takt TX für das Flip-Flop 6 abgeleitet. Mit dem Ausgangssignal des Flip-Flops 37 und dem Ausgangssignal DF des Decoders 15 wird mit der Und-Schaltung 41 ein Signal FD gebildet. Die Exklusiv-Oder-Schaltung 5 arbeitet als Inverter, wenn das Signal FD den Wert 1 annimmt, das heißt, das Flip-Flop 6 ist dann gesetzt und das Signal DF ist gleich 1.

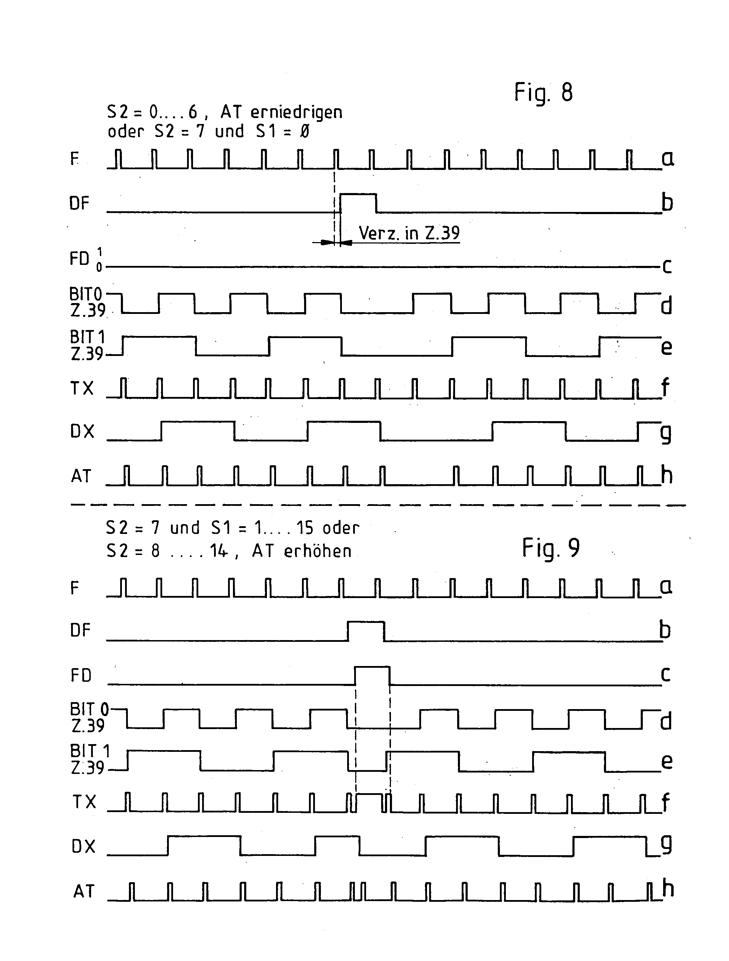

Für den Fall, daß S2 niedriger als 7 ist, ist der zeitliche Verlauf des Bits 1 in Zeile e, Fig. 8 dargestellt. Zum Vergleich ist das geringstwertige Bit 0 in Zeile d aufgetragen. Der in Fig. 8 dargestellte Zeitraum umschließt einen Wechsel zwischen dem Teilungsverhältnis 76:1 und 77:1. Bis zum Auftreten des Impulses DF (Zeile b) erfolgt eine Frequenzteilung durch 76. Dadurch weist das Bit 1 (Zeile e) bei jedem zweiten Impuls des Signals F eine Flanke auf. Das entsprechende gilt für das Ausgangssignal DX am Ausgang des Flip-Flops 6. Weil mit der positiven Flanke des Signals F (Zeile a), die in die Zeit fällt, in der das Signal DF = 1 ist (Zeile b) der Zähler 39 auf den Wert "52" geladen wird, entfällt bedingt durch den Ladevorgang ein Impuls im Signal AT (Zeile h).

In Fig. 9 ist dargestellt, wie ein Impuls dem Signal AT hinzugefügt wird. Zu diesem Zweck wird das Signal F, während FD = 1 ist, mit der Exklusiv-Oder-Schaltung 5 invertiert. Es ergibt sich das Taktsignal TX (Zeile f). Bei jeder positiven Flanke des Signals TX wird der Pegel des Signals in Zeile e in das Flip-Flop 6 übernommen. Auf diese Weise entsteht das in der Zeile g dargestellte Signal DX. Zum Zeitpunkt, zu dem die Exklusiv-Oder-Schaltung 5 zum Inverter wird, ergibt sich eine Signalflanke des Signals DX. Hieraus resultiert der zusätzliche Impuls im Signal AT (Zeile h). In der Zeit FD fällt noch ein Impuls des Signals F. Die Rückflanke (positive Flanke) dieses Impulses im Signal TX kann den Pegel des Signals DX noch nicht verändern, weil zu dem Zeitpunkt sich auch noch nicht der Pegel des Signals in Zeile e verändert hat.

Mit dem bisher erläuterten Teil der Schaltungsanordnung nach Fig. 1 können Frequenzabweichungen im Raster von etwa 1 kHz kompensiert werden, da diese einer Sollwertveränderung von 1 entsprechen. Mit weiteren Teilen der Schaltungsanordnung kann eine um den Faktor 16 feinere Stufung erreicht werden, so daß - bezogen auf die Hilfsträgerfrequenz von 57 kHz - Stufen von 0,41 Hz möglich sind.

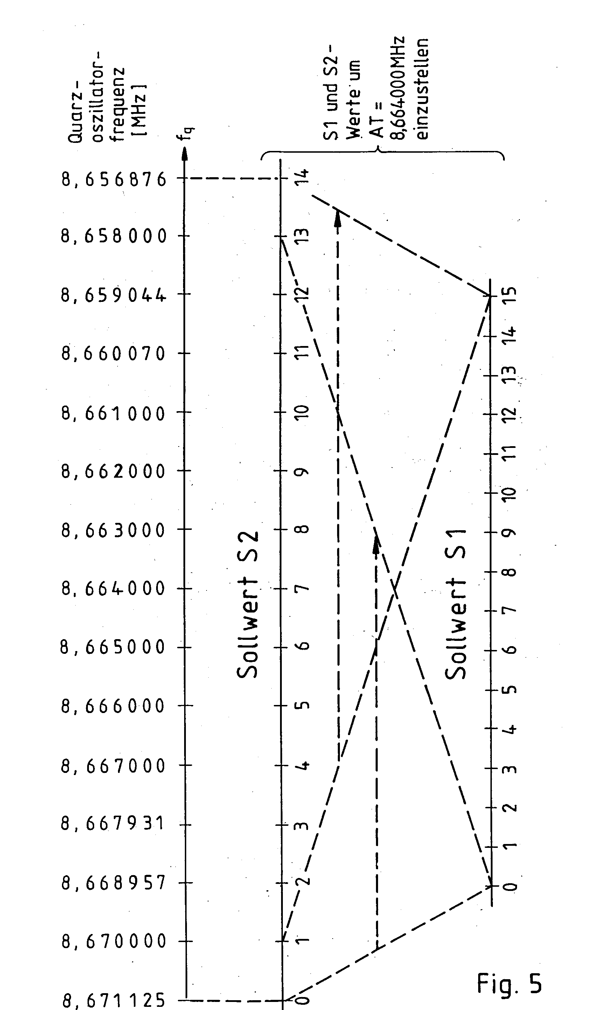

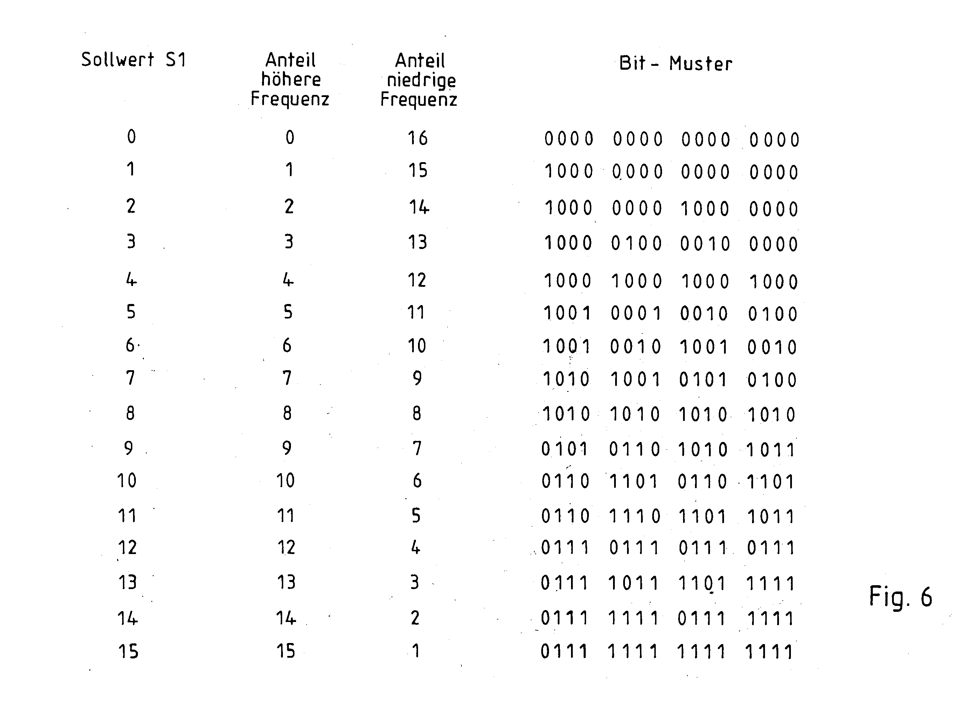

Fig. 5 zeigt schematisch die Einteilung des gesamten zu erfassenden Bereichs der Frequenz $f_q$, der entsprechend den Werten 0 bis 14 von S2 aufgeteilt ist. In jedem dieser Teilbereiche können mit Hilfe eines weiteren Sollwertes S1 15 Zwischenwerte ausgewählt werden. Das feinere Frequenzraster wird erreicht, indem benachbarte S2-Sollwerte abwechselnd in jeweils einem bestimmten Verhältnis zueinander benutzt werden. Die mit dem Sollwert S1 einstellbaren Verhältnisse sind in Fig. 6 angegeben. Zu jedem Sollwert S1 (0...15) gehört ein Bitmuster, mit dem die Umschaltung des Sollwertes S2 gesteuert wird. Diese Bitmuster sind in einer Matrix 23 abgelegt und werden mit Hilfe des Signals S1 aufgerufen und in ein 16 Bit Schieberegister 24 geladen. Jedes 16-Bit-Muster sorgt dafür, daß möglichst gleichmäßige Abschnitte je Schalterstellung eingehalten werden. Mit dieser Maßnahme werden die alternierend auftretenden Frequenzabweichungen zeitlich ausreichend gemittelt.

Nachdem der Zähler 12 n Perioden des Zählers 39 gezählt hat, wird eines der Flip-Flops 17, 18 für eine Periode des Signals F gesetzt. Mit der Oder-Schaltung 25 wird das Signal LS gewonnen, das zum Laden und Takten des Schieberegisters 24 verwendet wird. Die Taktimpulse gelangen über eine Und-Schaltung 43 zum Takteingang des Schieberegisters, wo mit der Vorderflanke des LS-Impulses die Daten im Kreis geschoben werden. Das Laden des Schieberegisters wird mit der Rückflanke des LS-Impulses vorgenommen. Das Schieberegister 24 muß immer dann neu geladen werden, wenn sich der Sollwert S1 geändert hat. In diesem Fall hat der Zähler 45, mit dem der Sollwert S1 vorgegeben wird, an einem seiner Eingänge 46 oder 47 einen Impuls U oder D erhalten. Dementsprechend liefert die Oder-Schaltung 48 einen Setzimpuls für das Flip-Flop 28.

Mit der Rückflanke des LS-Impulses wird das Flip-Flop 28 zurückgesetzt. Der Pegel am Ausgang der Verzögerung ist noch für kurze Zeit 1, wobei bereits das Signal $\overline{LS}$ schon wieder 1 ist. Mit der Und-Schaltung 44 wird auf diese Weise ein Ladeimpuls für das Schieberegister 24 erzeugt. Mit dem im Schieberegister 24 umlaufenden Bitmuster wird die Umschaltung des Sollwertes S2 gesteuert. Dazu wird das jeweils am Schieberegisterausgang stehende Bit mit der Vorderflanke des LS-Impulses in das Flip-Flop 26 übernommen. Der Impulsformer 27 leitet aus jeder positiven Flanke des Ausgangssignals des Flip-Flops einen Impuls PF und aus jeder negativen Flanke einen Impuls NF ab. Der Zählerstand des Zählers 49, der den Sollwert S2 vorgibt, erhöht sich bei jedem PF-Impuls um 1 und erniedrigt sich um 1 bei jedem NF-Impuls. Weil NF- und PF-Impulse alternierend auftreten, wechselt der Sollwert S2 zwischen benachbarten Werten. Der Sollwert S2 muß jedoch auch verändert werden können, wenn der Zähler 45 einen up- oder down-Übertragsimpuls liefert. Die Takteingänge des Zählers 49 sind deshalb mit Ausgängen von Oder-Schaltungen 50, 51 verbunden, die an ihren Eingängen Übertragsimpulse oder NF-, Pf-Impulse erhalten.

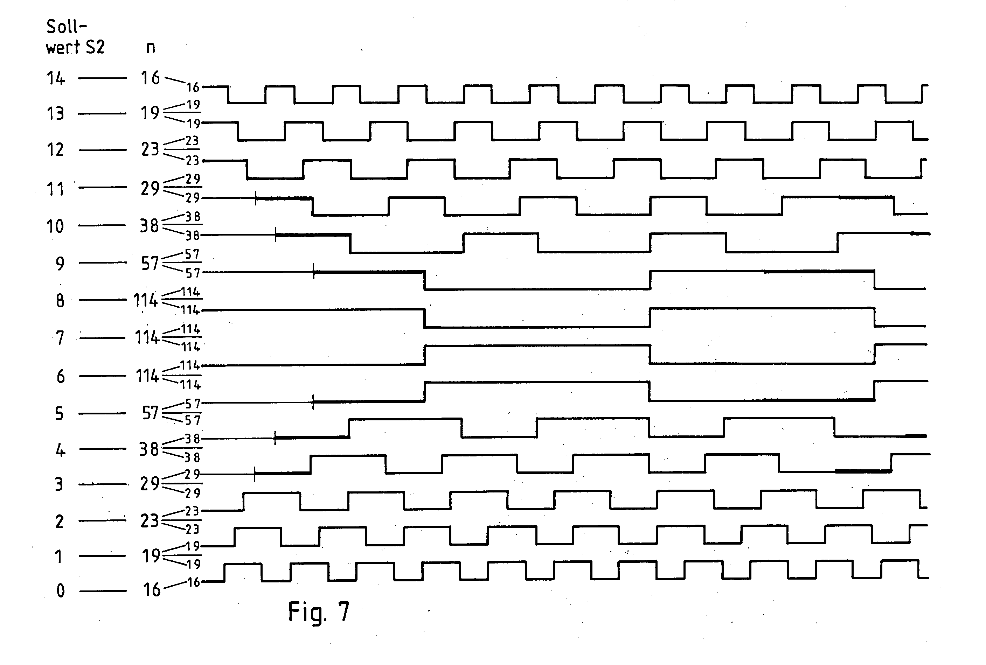

Zu benachbarten Werten von S2 können n-Werte gehören, die sich bis zum Faktor 2 voneinander unterscheiden (vergleiche Fig. 3). Es ist deshalb dafür zu sorgen, daß die durch die n-Werte gegebenen Zeitabschnitte, je S2-Stellung zeitlich gesehen, annähernd gleichwertig sind. Aus Fig. 7 geht hervor, daß Korrekturen von S2 = 3 bis S2 = 11 (ausgenommen S2 = 7) notwendig sind. Zur Veranschaulichung gelten die Impulsdiagramme in Bild 7 für S1 = 8 (vergleiche Bit-Muster in Fig. 6). Bei der Umschaltung zwischen S2 = 3 und S2 = 4 sowie zwischen S2 = 10 und S2 = 11 während jeder vierten Periode von DF, wenn S2 = 3 bzw. S2 = 11 ist, wird eine n-Zählperiode unabhängig vom Bit-Muster im Schieberegister 24 wiederholt. Das gleiche gilt entsprechend für jede dritte Periode von DF bei S2 = 4 bzw. S2 = 10 und jedes Mal bei S2 = 5 bzw. S2 = 9. Die Wiederholung ist in Fig. 7 durch starke Linien hervorgehoben.

Bei der Schaltungsanordnung nach Fig. 1 wird der Matrix 16 entnommen, welche beiden S2-Werte aktiv sind. Diese werden einer weiteren Matrix 31 vorgegeben, mit der dann abgeleitet wird, in welchen Abständen die Wiederholung ausgeführt wird. Das Ergebnis gelangt zu einem weiteren Komparator 32, dessen weiterer Eingang mit dem Ausgang eines weiteren Zählers 33 verbunden ist. Mit einem weiteren Ausgang der Matrix 31 können die von dem Impulsformer 27 kommenden Impulse über die Und-Schaltungen 34, 35 über die Oder-Schaltung 42 zum Hochzählen des Zählers 33 freigegeben werden.

Das Hochzählen wird freigegeben, wenn der Sollwert S2 einen der Werte 3 bis 6 oder 8 bis 11 angenommen hat. Dabei bestimmt das MSB des Sollwertes S2, ob die von den negativen oder positiven Flanken abgeleiteten Impulse NF bzw. PF wirksam sind, denn wie aus Fig. 7 zu entnehmen ist, wird entweder die Zählperiode des kleineren S2-Wertes (S2 = 3, 4, 5) oder des größeren S2-Wertes (S2 = 9, 10, 11) wiederholt. Wenn der Komparator 32 Gleichheit feststellt, wird ein Flip-Flop 36 gesetzt und der Zähler 33 wieder rückgesetzt. Damit wird der nächste Taktimpuls für das Flip-Flop 26 und das Schieberegister 24 mit Hilfe der Und-Schaltung 43 gesperrt. Folglich wird der Sollwert S2 nicht umgeschaltet, weil weder ein NF- noch ein PF-Impuls entsteht. Die Taktimpulssperre wird mit der Vorderflanke des nächsten LS-Impulses wieder aufgehoben, indem das Flip-Flop 36 wieder rückgesetzt wird, so daß die Und-Schaltung die LS-Impulse wieder zu den Takteingängen weiterleiten kann.

## Patentansprüche

1. Schaltungsanordnung zur Erzeugung eines Signals mit einer steuerbaren stabilen Frequenz, dadurch gekennzeichnet,
   - daß mit Hilfe eines Quarzoszillators ein impulsförmiges Signal erzeugt wird, dessen Frequenz durch Hinzufügen und Unterdrücken von Impulsen veränderbar ist, und
   - daß das Hinzufügen oder Unterdrücken der Impulse je nach Richtung der Frequenzabweichung des erzeugten Signals von einer Sollfrequenz erfolgt.

2. Schaltungsanordnung nach Anspruch 1, dadurch gekennzeichnet,
   - daß eine grobe und eine feine Frequenzeinstellung vorgesehen sind, die Frequenzeinstellungen kombinierbar sind und die feine Frequenzeinstellung durch eine bitmusterabhängige alternierende grobe Frequenzeinstellung realisiert wird,
   - daß die Bitmuster so gewählt sind, daß die hinzugefügten bzw. unterdrückten Impulse zeitlich gleichmäßig verteilt werden, und

- daß die erzeugte Frequenz der Sollfrequenz oder einem Teil oder einem Vielfachen davon entspricht.

**3.** Schaltungsanordnung nach Anspruch 2, dadurch gekennzeichnet, daß als Korrekturwert eine Zahl für die grobe Frequenzeinstellung eingebbar ist, welche die Anzahl der mit der Quarzoszillatorfrequenz gezählten Perioden kennzeichnet, nach denen jeweils ein Impuls hinzugefügt oder unterdrückt wird.

**4.** Schaltungsanordnung nach Anspruch 3 für die Demodulation von Radio-Daten-Signalen, deren Übertragung durch Phasenumtastung eines unterdrückten Hilfsträgers erfolgt, dadurch gekennzeichnet, daß die Anzahl der mit der-Quarzoszillatorfrequenz gezählten Perioden der doppelten Frequenz des Hilfsträgers entspricht.

**5.** Schaltungsanordnung nach Anspruch 3, dadurch gekennzeichnet, daß die Zahl mit Hilfe eines Vorwärts/Rückwärtszählers eingegeben wird, der abhängig von einer anderen weiteren Zahleneingabe für die feine Frequenzeinstellung um jeweils 1 aufwärts und abwärts steuerbar ist.

**6.** Schaltungsanordnung nach Anspruch 4, dadurch gekennzeichnet, daß das mittlere Teilungsverhältnis 76:1 und zwei weitere Teilungsverhältnisse 75:1 und 77:1 betragen.

**7.** Schaltungsanordnung nach Anspruch 6, dadurch gekennzeichnet, daß das Ausgangssignal vom zweitniederwertigsten Bit des Zählerstandes abgeleitet wird.

**8.** Schaltungsanordnung nach Anspruch 4, dadurch gekennzeichnet, daß eine zeitliche Korrektur dadurch, daß unabhängig von festen Vorgaben Zählperioden der einen Verhältnisseite wiederholt werden, erfolgt, wenn sich die Anzahl der gezählten Perioden der beiden Eingabewerte für die grobe Frequenzeinstellung stark voneinander unterscheiden.

**9.** Schaltungsanordnung nach einem der vorhergehenden Ansprüche, dadurch gekennzeichnet, daß Sollwerte als digitale Daten in codierter Form zuführbar sind und mit Hilfe von Matrizen in die Zahlen umwandelbar sind.

**10.** Schaltungsanordnung nach Anspruch 1 für die Demodulation von Radio-Daten-Signalen, deren Übertragung durch Phasenumtastung eines unterdrückten Hilfsträgers erfolgt, dadurch gekennzeichnet, daß die Sollfrequenz einem ganzzahligen Vielfachen der Frequenz des Hilfsträgers entspricht.

Fig. 1

EP 0 597 486 A2

$$n = \frac{1}{76-TF}$$

| Quarzoszillator-frequenz [MHz] | Ablage [KHz] | doppelte Quarz-oszillatorfrequenz [MHz] | n errechnet | n gewählt |
|---|---|---|---|---|
| 4,328500 | - 3,5 | 8,657000 | 16,28 | 16 |
| 4,329000 | - 3,0 | 8,658000 | 18,99 | 19 |
| 4,329500 | - 2,5 | 8,659000 | 22,79 | 23 |
| 4,330000 | - 2,0 | 8,660000 | 28,49 | 29 |
| 4,330500 | - 1,5 | 8,661000 | 37,98 | 38 |
| 4,331000 | - 1,0 | 8,662000 | 56,97 | 57 |
| 4,331500 | - 0,5 | 8,663000 | 113,90 | 114 |
| 4,332000 | 0 | 8,664000 | - | 114 |

$$n = \frac{1}{TF-76}$$

| Quarzoszillator-frequenz [MHz] | Ablage [KHz] | doppelte Quarz-oszillatorfrequenz [MHz] | n errechnet | n gewählt |
|---|---|---|---|---|
| 4,332500 | + 0,5 | 8,665000 | 114,09 | 114 |
| 4,333000 | + 1,0 | 8,666000 | 57,02 | 57 |
| 4,333500 | + 1,5 | 8,667000 | 38,01 | 38 |
| 4,334000 | + 2,0 | 8,668000 | 28,50 | 29 |
| 4,334500 | + 2,5 | 8,669000 | 22,80 | 23 |
| 4,335000 | + 3,0 | 8,670000 | 19,00 | 19 |
| 4,335500 | + 3,5 | 8,671000 | 16,28 | 16 |

Fig. 2

$$F = \frac{76 - \frac{1}{n}}{T}$$

| gewähltes n | doppelte Quarz-oszillatorfrequenz [MHz] | Quarzoszillator-frequenz [MHz] | Ablage [Hz] | Sollwert S2 |
|---|---|---|---|---|
| 16 | 8,656876 | 4,328438 | -3562 | 14 |
| 19 | 8,658000 | 4,329000 | -3000 | 13 |
| 23 | 8,659044 | 4,329522 | -2478 | 12 |
| 29 | 8,660070 | 4,330035 | -1965 | 11 |
| 38 | 8,661000 | 4,330500 | -1500 | 10 |
| 57 | 8,662000 | 4,331000 | -1000 | 9 |
| 114 | 8,663000 | 4,331500 | -500 | 8 |
| 114 | 8,664000 | 4,332000 | 0 | 7 |
|  | (n = ∞) | | | |

$$F = \frac{76 + \frac{1}{n}}{T}$$

| 114 | 8,665000 | 4,332500 | +500 | 6 |
|---|---|---|---|---|
| 57 | 8,666000 | 4,333000 | +1000 | 5 |
| 38 | 8,667000 | 4,333500 | +1500 | 4 |
| 29 | 8,667931 | 4,333965 | +1965 | 3 |
| 23 | 8,668957 | 4,334478 | +2478 | 2 |
| 19 | 8,670000 | 4,335000 | +3000 | 1 |
| 16 | 8,671125 | 4,335562 | +3562 | 0 |

Fig. 3

| Sollwert S2 | n dez. | n binär |
|---|---|---|
| 14 | 16 | 001 0000 |
| 13 | 19 | 001 0011 |
| 12 | 23 | 001 0111 |
| 11 | 29 | 001 1101 |
| 10 | 38 | 010 0110 |
| 9 | 57 | 011 1001 |
| 8 | 114 | 111 0010 |
| 7 | – | 111 0010 |
| 6 | 114 | 111 0010 |
| 5 | 57 | 011 1001 |
| 4 | 38 | 010 0110 |
| 3 | 29 | 001 1101 |
| 2 | 23 | 001 0111 |
| 1 | 19 | 001 0011 |
| 0 | 16 | 001 0000 |

Fig. 4

Fig. 5

| Sollwert S1 | Anteil höhere Frequenz | Anteil niedrige Frequenz | Bit - Muster |
|---|---|---|---|
| 0 | 0 | 16 | 0000 0000 0000 0000 |
| 1 | 1 | 15 | 1000 0000 0000 0000 |
| 2 | 2 | 14 | 1000 0000 1000 0000 |
| 3 | 3 | 13 | 1000 0100 0010 0000 |
| 4 | 4 | 12 | 1000 1000 1000 1000 |
| 5 | 5 | 11 | 1001 0001 0010 0100 |
| 6 | 6 | 10 | 1001 0010 1001 0010 |
| 7 | 7 | 9 | 1010 1001 0101 0100 |
| 8 | 8 | 8 | 1010 1010 1010 1010 |
| 9 | 9 | 7 | 0101 0110 1010 1011 |
| 10 | 10 | 6 | 0110 1101 0110 1101 |
| 11 | 11 | 5 | 0110 1110 1101 1011 |
| 12 | 12 | 4 | 0111 0111 0111 0111 |
| 13 | 13 | 3 | 0111 1011 1101 1111 |
| 14 | 14 | 2 | 0111 1111 0111 1111 |
| 15 | 15 | 1 | 0111 1111 1111 1111 |

Fig. 6

EP 0 597 486 A2

Fig. 7

EP 0 597 486 A2

Fig. 8

S2 = 0....6 , AT erniedrigen
oder S2 = 7 und S1 = Ø

Verz. in Z.39

Fig. 9

S2 = 7 und S1 = 1....15 oder
S2 = 8 .... 14 , AT erhöhen

14